# EUROPÄISCHE PATENTSCHRIFT

(11) **EP 1 497 914 B1**
(45) Veröffentlichungstag und Bekanntmachung des Hinweises auf die Patenterteilung: **10.08.2005**
(21) Anmeldenummer: 03738070.6
(22) Anmeldetag: 20.06.2003
(51) Int. Cl.: H03F 3/08, H04N 3/15

(54) **SENSORSCHALTUNG**
SENSOR CIRCUIT
CIRCUIT CAPTEUR

(30) Priorität: 20.06.2002 DE 10227622
(43) Veröffentlichungstag der Anmeldung: 19.01.2005
(73) Patentinhaber: Fraunhofer-Gesellschaft zur Förderung der angewandten Forschung e.V., 80636 München (DE)
(72) Erfinder: ERNST, Roland, 91052 Erlangen (DE)
(74) Vertreter: Schoppe, Fritz, Dipl.-Ing.
(86) Internationale Anmeldenummer: PCT/EP2003/006506
(87) Internationale Veröffentlichungsnummer: WO 2004/001959

(56) Entgegenhaltungen:
- EP-A- 1 026 880
- GB-A- 2 351 867
- US-A- 6 084 229
- US-A- 6 130 423

## Beschreibung

Die vorliegende Erfindung befaßt sich mit einer Sensorschaltung. Insbesondere befaßt sich die Erfindung mit einer Sensorschaltung, bei der ein Signal an einem hochohmigen Sensor abzugreifen ist und über eine Signalstrecke bzw. Signalübertragungseinrichtung zu einem anderen, typischerweise entfernten Ort zu übertragen ist, an dem das Signal beispielsweise durch Verstärkung weiterzuverarbeiten ist.

Es gibt in der Elektrotechnik viele Anwendungsfälle, bei denen ein von einer hochohmigen Signalquelle stammendes Signal zunächst über eine Signalstrecke oder Signalübertragungseinrichtung übertragen werden muß, bevor eine Weiterverarbeitung des Signals möglich ist. Diese Problematik tritt immer dann auf, wenn auf der Seite der Signalquelle bzw. des Sensors nicht genügend Platz für die Anordnung eines Verstärkers direkt an der Quelle zur Verfügung steht.

Diese Problematik soll im folgenden am Beispiel eines elektronischen Bildsensors verdeutlicht werden, wobei jedoch hervorgehoben sein soll, daß der Begriff "Sensor" im Sinne der vorliegenden Patentanmeldung nicht auf Bildsensoren beschränkt ist, sondern alle Arten von Signalquellen einschließt.

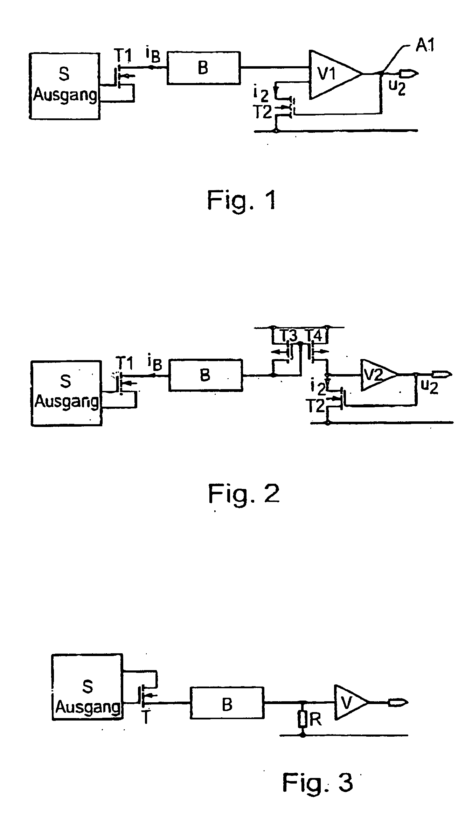

Die typische Beschaltung eines Bildsensors ist in Figur 3 gezeigt, in der mit dem Bezugszeichen S ein hochohmiger Sensor bezeichnet ist. Im Beispielsfall kann es sich um ein Sensorpixel aus einem Bildsensorarray handeln. Der Sensor S kann auch eine übliche Ansteuerung, eine Sample-Hold-Stufe oder ähnliche Schaltungsstrukturen umfassen, die den die erfaßte Lichtmenge eines Sensors darstellenden Ladungswert in einen Spannungswert abbildet, der an einem typischerweise hochohmigen Ausgang des Sensors anliegt. Mit dem Sensorausgang ist ein erster Transistor T in Source-Folger-Schaltung verbunden, dessen Source mit einer Seite einer Signalübertragungseinrichtung B verbunden ist, welche beispielsweise aus einer Leitung, Multiplexern oder allgemein aus einer Strecke besteht, die zu einer noch zu diskutierenden externen Verstärkerschaltung führt. Auf der anderen Seite ist die Signalübertragungseinrichtung B an eine ausgangsseitige Verstärkerschaltung V angeschlossen, die das Signal hochohmig abgreift und es typischerweise an einen Analog-digital-Umsetzer weiterleitet. Mit dem Bezugszeichen R sei der Arbeitswiderstand des Source-Folgers bezeichnet, der die Verstärkerschaltung bildet.

Im Falle eines elektronischen Bildsensors befinden sich der Sensor S (gegebenenfalls mit zugehöriger Ansteuerung, Sample-Hold-Stufe) sowie der erste Transistor T innerhalb des Bildsensorarrays, während der Arbeitswiderstand R und der Verstärker V sich am Rande des Arrays befinden. In diesem Fall ist die Signalübertragungseinrichtung B ein Bus, der beispielsweise alle Pixel einer Spalte auf einen gemeinsamen Block mit Verstärker V und Arbeitswiderstand R zusammenführt. Wegen der zu geringen zur Verfügung stehenden Fläche eines Pixels innerhalb eines Bildsensorarrays kann der erste Transistor T nicht als komplexer Verstärker ausgeführt werden, sondern nur als einfacher Source-Folger.

Ein erstes Problem bei dieser bekannten Bildsensorschaltung liegt in der Gate-Source-Spannung des ersten Transistors T begründet. Diese streut zwischen den verschiedenen Transistoren innerhalb des Bildsensorarrays und ist temperaturabhängig. Außerdem ist sie arbeitspunktabhängig, d.h. sie hängt vom Drainstrom des Transistors und von der Source-Bulk-Spannung ab. Wegen dieser Fehlergrößen bzw. der durch diese bedingten Offset-Spannungen kann die eigentliche Ausgangsspannung des Sensors S nur ungenau am Ausgang der Sensorschaltung abgebildet werden.

Aus der GB 2351867 A ist ein Bildsensorarray bekannt, bei dem jedem Bildsensorelement, das durch eine Photodiode gebildet ist, jeweils ein Verstärkungstransistor zugeordnet ist, dem außerhalb des Arrays ein weiterer Transistor entspricht. Dieser außerhalb des Arrays angeordnete Transistor ist als Spannungsfolger geschaltet.

Ausgehend von diesem Stand der Technik liegt der vorliegenden Erfindung die Aufgabe zugrunde, eine Sensorschaltung zu schaffen, bei der ein Spannungsabfall bei der Signalübertragung zwischen dem Sensor und einer von dem Sensor entfernten Signalverarbeitungseinrichtung über eine Signalübertragungseinrichtung nicht zu einem Fehler des erfaßten Ausgangssignals führt.

Diese Aufgabe wird durch eine Sensorschaltung gemäß Anspruch 1 gelöst.

Der Erfindung liegt die Erkenntnis zugrunde, daß dann die Vorteile einer Signalübertragung als Stromgröße über die Signalübertragungseinrichtung ohne den Aufwand linear arbeitender sensorseitiger Spannungs-Strom-Wandler und linear arbeitender ausgangsseitiger Strom-Spannungs-Wandler erreicht werden können, wenn zur Spannungs-Strom-Wandlung des Sensorsignals ein einfaches nicht-lineares Verstärkerelement, wie beispielsweise ein Feldeffekttransistor, genutzt wird und wenn die ausgangsseitig mit der Signalübertragungseinrichtung verbundene Signalverarbeitungseinrichtung ein zweites nicht-lineares Verstärkungselement, wie beispielsweise einen zweiten Feldeffekttransistor und einen Strom-Spannungs-Verstärker aufweist, wobei ein Ausgang der Signalverarbeitungseinrichtung durch einen Ausgang des Strom-Spannungs-Verstärkers gebildet wird, der mit einem Eingang des zweiten nicht-linearen Verstärkungselements in Wirkverbindung steht, so daß sich die Nicht-Linearitäten der beiden nicht-linearen Verstärkungselemente weitgehend kompensieren.

Bei der in Figur 1 gezeigten Sensorschaltung ist wiederum der Sensor mit dem Bezugszeichen S bezeichnet. Der hochohmige Sensorausgang ist mit einem Gate eines n-Kanal-MOS-Feldeffekttransistors T1 verbunden. Der durch die Drain-Source-Strecke dieses Transistors T1 fließende Strom i_{B} hängt in stark nicht-linearer Form von seiner Gate-Spannung ab.

Ausgangsseitig ist der erste Transistor T1 mit einer Signalübertragungseinrichtung B auf ihrer einen Seite verbunden. Die Signalübertragungseinrichtung kann beispielsweise eine Leitung sein. Innerhalb eines integrierten Bildsensors kann sie Leitungen und Multiplexer zwischen dem Sensorpixel und dem Rand des Bildsensorarrays darstellen.

Die Signalübertragungseinrichtung B ist auf ihrer anderen Seite mit einem ersten Stromeingang eines Transimpedanzverstärkers V1 mit zwei Stromeingängen und einem Spannungsausgang verbunden. Der Spannungsausgang bildet gleichzeitig den Ausgang A1 der Sensorschaltung. Der andere Stromeingang des Transimpedanzverstärkers V1 ist mit dem Drain eines zweiten n-Kanal-MOS-Feldeffekttransistors T2 verbunden, dessen Source mit Bezugspotential verbunden und dessen Gate mit dem Ausgang A1 verbunden ist.

Die Ausgangsspannung U2 des Transimpedanzverstärkers V1 stellt sich als Differenz der Eingangsströme so ein, daß im Idealfall die Eingangsströme einander betragsmäßig entsprechen. Die beiden Feldeffekttransistoren T1, T2 sind so gewählt, daß sie übereinstimmende elektrische Charakteristika haben, d.h. bei gegebener Spannung an ihrem Gate übereinstimmende Drain-Source-Ströme haben. Somit kompensieren sich die Nicht-Linearitäten der Spannungs-Strom-Charakteristika der beiden als erste und zweite nicht-lineare Verstärkungselemente verwendeten n-Kanal-MOS-Feldeffekttransistoren.

Während die unter Bezugnahme auf Figur 1 diskutierte Schaltung dahingehend beschränkt ist, daß die beiden Feldeffekttransistoren T1, T2 in ihren elektrischen Charakteristika identisch miteinander übereinstimmen, erreicht man mit der nachfolgend unter Bezugnahme auf Figur 2 zu erläuternden Schaltung bezüglich der Wahl der verwendeten Transistoren eine größere Freiheit.

Die in Figur 2 gezeigte Schaltung unterscheidet sich von der in Figur 1 gezeigten Schaltung lediglich dadurch, daß hier eine Stromspiegel-Schaltung T3, T4 zwischen die Signalübertragungseinrichtung B und den Eingang der Signalverarbeitungseinrichtung geschaltet ist, welche durch das zweite nicht-lineare Verstärkungselement T2 und den Strom-Spannungs-Verstärker gebildet ist, der jedoch hier durch einen einfachen Spannungs-Spannungs-Verstärker V2 oder Strom-Spannungs-Verstärker V2 mit einem einzigen Stromeingang gebildet ist. Diese Schaltung ermöglicht es, auf Seiten der Signalverarbeitungseinrichtung mit einem anderen Stromniveau zu arbeiten. So ist es beispielsweise möglich, den Strom 12 dadurch um einen beliebigen Faktor verglichen mit dem Strom i_{B} größer oder kleiner festzulegen, daß die Dimensionierung des Transistors T4 um diesen Faktor über oder unter der Dimensionierung des Transistors T3 des Stromspiegels liegt. Dies ermöglicht es, den Transistor T2 ebenfalls um diesen Faktor größer zu dimensionieren als den Transistor T1, wobei dennoch der Transistor T1 und der Transistor T2 am gleichen Arbeitspunkt innerhalb ihrer nicht-linearen Spannungs-Strom-Kennlinie arbeiten.

Beim bevorzugten Ausführungsbeispiel wurden für beide Transistoren n-Kanal-MOS-FETs verwendet. Natürlich können auch p-Kanal-MOS-FETs oder Transistoren anderer Technologien, wie beispielsweise Bipolartransistoren, verwendet werden.

Beim bevorzugten Ausführungsbeispiel besteht der Sensor aus einem Bildsensorpixel innerhalb eines Bildsensorarrays mit zugehöriger Ansteuerschaltung und Sample-Hold-Stufe. Die Erfindung eignet sich jedoch auch für andere Sensoren, die örtlich beabstandet von einer Signalverarbeitungseinheit angeordnet werden müssen und findet immer dann bevorzugte Anwendung, wenn es sich bei dem Sensor um einen Sensor mit hochohmigen Ausgang handelt. Als Sensor im Sinne der Anmeldung seien auch andere Signalquellen zu verstehen.

Die Anordnung der Quellen ist dabei nicht auf zweidimensionale Arrays beschränkt, sondern kann z.B. auch als Zeile oder Einzelelement ausgeführt sein oder allgemein N-dimensional sein. Das Konzept der Erfindung eignet sich für beliebige geordnete oder ungeordnete Ansammlungen von Quellen.

Bei elektronischen Bildsensoren befinden sich meist die Elemente der Sensorschaltung auf einem Mikrochip. Das erfindungsgemäße Konzept kann jedoch auch auf Schaltungen angewendet werden, bei denen die Baugruppen beliebig verteilt sind.

## Patentansprüche

1. Sensorschaltung, mit
einem Sensor (S) mit einem Spannungsausgangssignal,
einem ersten nicht-linearen Verstärkerelement (T1), das eingangsseitig mit dem Spannungsausgang des Sensors (S) beaufschlagt ist und an seinem Ausgang ein Stromausgangssignal liefert,
eine auf ihrer einen Seite mit dem Ausgang des ersten nicht-linearen Verstärkerelements (T1) in Wirkverbindung stehende Signalübertragungseinrichtung (B), und
eine ein zweites nicht-lineares Verstärkerelement (T2) und einen Verstärker (V1; V2) aufweisende Signalverarbeitungseinrichtung, die mit der anderen Seite der Signalübertragungseinrichtung B in Wirkverbindung steht, bei der ein Ausgang der Signalverarbeitungseinrichtung mit einem Ausgang des Verstärkers (V1; V2) und mit einem Eingang des zweiten nicht-linearen Verstärkungselements (T2) in Wirkverbindung steht, so daß sich die Nicht-Linearitäten des ersten und zweiten nicht-linearen Verstärkungselements (T1, T2) kompensieren.

2. Sensorschaltung nach Anspruch 1, bei dem das erste und das zweite nicht-lineare Verstärkerelement durch Transistoren gebildet sind.

3. Sensorschaltung nach Anspruch 2, bei dem die Transistoren durch Feldeffekttransistoren gebildet sind.

4. Sensorschaltung nach einem der Ansprüche 1 bis 3, bei dem der Verstärker (V1) ein Transimpedanzverstärker mit zwei Stromeingängen ist, von denen einer mit der anderen Seite der Signalübertragungseinrichtung (B) in Wirkverbindung steht und der andere mit der Ausgangsseite des zweiten nicht-linearen Verstärkungselements verbunden ist.

5. Sensorschaltung nach einem der Ansprüche 1 bis 3, bei der der Verstärker (V2) ein Strom-Spannungs-Verstärker mit einem Stromeingang oder ein Spannungs-Spannungs-Verstärker (V2) mit einem Spannungseingang ist, der mit der anderen Seite der Signalübertragungseinrichtung (B) in Wirkverbindung steht und der ferner mit der Ausgangsseite des zweiten nicht-linearen Verstärkerelements verbunden ist.

6. Sensorschaltung nach Anspruch 5, bei der zwischen dem Eingang des Strom-Spannungs-Verstärkers und der anderen Seite der Signalübertragungseinrichtung B eine Stromspiegel-Schaltung T3, T4 vorgesehen ist.

## Claims

1. A sensor circuit, comprising
a sensor (S) having a voltage output signal,
a first non-linear amplifier element (T1) which is pulsed with the voltage output of a sensor (S) on the input side and provides a current output signal at its output,
a signal transmission means (B) which is operatively connected to the output of the first non-linear amplifier elements (T1) on its one side and
a signal processing means comprising a second non-linear amplifier element (T2) and an amplifier (V1; V2), which is operatively connected to the other side of the signal transmission means (B), wherein one output of the signal processing means is operatively connected to one output of the amplifier (V1; V2) and to one input of the second non-linear amplifying element (T2), so that the non-linearites of the first and the second non-linear amplifying element (T1, T2) compensate each other.

2. The sensor circuit according to claim 1, wherein the first and the second non-linear amplifier elements are formed by transistors.

3. The sensor circuit according to claim 2, wherein the transistors are formed by field effect transistors.

4. The sensor circuit according to one of claims 1 to 3, wherein the amplifier (V1) is a transimpedance amplifier having two current inputs of which one is operatively connected to the other side of the signal transmission means (B) and the other one is connected to the output side of the second non-linear amplifying element.

5. The sensor circuit according to one of claims 1 to 3, wherein the amplifier (V2) is a current-voltage amplifier having a current input or a voltage-voltage amplifier (V2) having a voltage input which is operatively connected to the other side of the signal transmission means (B) and which is further connected to the output side of the second non-linear amplifier element.

6. The sensor circuit according to claim 5, wherein between the input of the current-voltage amplifier and the other side of the signal transmission means (B) a current mirror circuit (T3, T4) is provided.

## Revendications

1. Circuit capteur, avec
un capteur (S) avec un signal de sortie de tension,
un premier élément amplificateur non linéaire (T1) qui est soumis, du côté de l'entrée, à la sortie de tension du capteur (S) et qui fournit, à sa sortie, un signal de sortie de courant,
un dispositif de transmission de signal (B) qui est en communication active, à l'un de ses côtés, avec la sortie du premier élément amplificateur non linéaire (T1), et
un dispositif de traitement de signaux, présentant un deuxième élément amplificateur non linéaire (T2) et un amplificateur (V1 ; V2), qui est en communication active avec l'autre côté du dispositif de transmission de signal B, dans lequel une sortie du dispositif de traitement de signaux est en communication active avec une sortie de l'amplificateur (V1 ; V2) et avec une entrée du deuxième élément amplificateur non linéaire (T2), de sorte que les non-linéarités des premier et deuxième éléments amplificateurs non linéaires (T1, T2) se compensent.

2. Circuit capteur selon la revendication 1, dans lequel le premier et le deuxième élément amplificateur non linéaire sont formés par des transistors.

3. Circuit capteur selon la revendication 2, dans lequel les transistors sont constitués par des transistors à effet de champ.

4. Circuit capteur selon l'une des revendications 1 à 3, dans lequel l'amplificateur (VI) est un amplificateur de transimpédance avec deux entrées de courant dont l'une est en communication active avec l'autre côté du dispositif de transmission de signal (B) et l'autre est reliée au côté de la sortie du deuxième élément amplificateur non linéaire.

5. Circuit capteur selon l'une des revendications 1 à 3, dans lequel l'amplificateur (V2) est un amplificateur de courant-tension avec une entrée de courant ou un amplificateur de tension-tension (V2) avec une entrée de tension qui est en communication active avec l'autre côté du dispositif de transmission de signal (B) et qui est reliée, par ailleurs, au côté de sortie du deuxième élément amplificateur non linéaire.

6. Circuit capteur selon la revendication 5, dans lequel est prévu, entre l'entrée de l'amplificateur de courant-tension et l'autre côté du dispositif de transmission de signal B, un circuit de courant en rapport géométrique T3, T4.
